# EUROPEAN PATENT APPLICATION

(11) **EP 3 293 730 A1**
(43) Date of publication of application: **14.03.2018**
(21) Application number: 17177085.2
(22) Date of filing: 21.06.2017
(51) Int. Cl.: G09G 3/36

(54) **ARRAY SUBSTRATE AND DISPLAY DEVICE USING THE SAME**

(30) Priority: 07.09.2016 TW 105128968
(71) Applicant: AU Optronics Corporation, Hsin-Chu (TW)
(72) Inventor: WU, Wen-Ching, Hsin-Chu (TW); SHEN, Po-Yuan, Hsin-Chu (TW); CHEN, Yao-Ming, Hsin-Chu (TW)
(74) Representative: Jakelski & Althoff Patentanwälte PartG mbB

(57) **Abstract**

An array substrate includes a substrate having a display region and a peripheral region, at least one scan line, at least one data line, at least one pixel unit electrically connected to the scan line and the data line and disposed in the display region, and a gate driving circuit. The gate driving circuit is disposed in the peripheral region and includes multiple shift registers sequentially disposed on the substrate along a first direction. At least one shift register includes a pull-up unit, which includes a first transistor configured to output a gate signal to the scan line. The first transistor includes a first gate, a first channel layer, and a first source and a first drain which respectively have at least one bar portion. A first channel length is between two adjacent bar portions of the first source and the first drain, which extends along the first direction.

## Description

### FIELD

The present invention relates to an array substrate and a display device, and in particular, to a curved array substrate and a curved display device.

### BACKGROUND

With the progress of science and technology, technologies of display devices (for example, computer or television screens) have also been constantly developing. Flat displays and curved displays are common in the current market. With respect to the flat displays, curved displays not only can make human eyes more balanced and comfortable to watch images, but also have a broader panoramic angle of view and reduces external light reflection interference, so that deformation and distortion do not occur to images, which are watched by a user, of each corner of the curved display. Therefore, the curved displays are commonly favored by consumers in recent years.

### SUMMARY

The present invention provides an array substrate, including a substrate, at least one scan line, at least one data line, at least one pixel unit, and a gate driving circuit. The substrate has a display region and a peripheral region located on at least one side of the display region. The data line is intersected with the scan line. The pixel unit is electrically connected to the scan line and the data line. The at least one pixel unit is disposed in the display region of the substrate. The gate driving circuit is disposed in the peripheral region. The gate driving circuit includes a plurality of shift registers sequentially disposed on the substrate along a first direction, and at least one of the shift registers includes a pull-up unit. The pull-up unit includes a first transistor, configured to output a gate signal to the scan line. The first transistor includes a first gate, a first channel layer, a first source, and a first drain. The first source and the first drain are disposed corresponding to the first gate and the first channel layer. The first source and the first drain respectively have at least one bar portion. There is a first channel length between the bar portion of the first source and the bar portion of the first drain, which are adjacent to each other. An extending direction of the first channel length is along the first direction.

In an embodiment of the present invention, the first drain includes two bar portions, the first drain further includes a connection portion connected to the two bar portions of the first drain, and the two bar portions of the first drain and the bar portion of the first source are alternately disposed along the first direction.

In an embodiment of the present invention, a shape of the first drain includes a U shape, and a shape of the first source includes an I shape.

In an embodiment of the present invention, the I shape of the first source extends along an extending direction of the scan line.

In an embodiment of the present invention, the first drain is electrically connected to the scan line.

In an embodiment of the present invention, the at least one shift register further includes an input unit, configured to output a driving control voltage to the first gate of the first transistor of the pull-up unit. The input unit includes a second transistor. The second transistor includes a second gate, a second channel layer, a second source, and a second drain. The second source and the second drain are disposed corresponding to the second gate and the second channel layer. The second source and the second drain respectively have at least one bar portion. There is a second channel length between the bar portions of the second source and the bar portions of the second drain, which are adjacent to each other. An extending direction of the second channel length is along the first direction.

In an embodiment of the present invention, the first gate is electrically connected to the second drain.

In an embodiment of the present invention, the at least one of the plurality of shift registers further includes a pull-down unit, configured to pull down the gate signal outputted by the pull-up unit to a low power supply voltage.

In an embodiment of the present invention, the pull-down unit includes a third transistor. The third transistor includes a third gate, a third channel layer, a third source, and a third drain. The third source and the third drain are disposed corresponding to the third gate and the third channel layer. The third source and the third drain respectively have at least one bar portion. There is a third channel length between the bar portions of the third source and the bar portion of the third drain, which are adjacent to each other. An extending direction of the third channel length is along the first direction.

In an embodiment of the present invention, the first drain and the first gate of the first transistor of the pull-up unit are electrically connected to the pull-down unit.

In an embodiment of the present invention, the first source is configured to be electrically connected to a clock signal source.

In an embodiment of the present invention, there is a first channel width between the first source and the first drain of the first transistor. A region constituted by the first channel length extending along the first direction has an occupied length. A ratio of the occupied length to the first channel width is more than 50%.

The present invention provides a display device, including a display panel and a backlight module. The display panel has a display surface that bends along a curvature central axis. The display panel includes an array substrate, an opposite substrate, and a display medium. The array substrate includes a substrate, a plurality of scan lines, a plurality of data lines, a plurality of pixel units, and a gate driving circuit. The substrate has a display region and a peripheral region. The data lines are intersected with the scan lines. The pixel units are electrically connected to the scan lines and the data lines. The pixel units are disposed in the display region of the substrate. The gate driving circuit is disposed in the peripheral region. The gate driving circuit includes at least one shift register. The at least one shift register includes a pull-up unit. The pull-up unit includes a first transistor. The first transistor includes a first gate, a first channel layer, a first source, and a first drain. The first source and the first drain are disposed overlapping with the first channel layer. The first drain is electrically connected to the corresponding scan line. There is a first channel width and a first channel length between the first source and the first drain. A region constituted by the first channel length along an extending direction of the curvature central axis has an occupied length. A ratio of the occupied length of the first channel length along an extending direction of the curvature central axis to the first channel width is more than 50%. The display medium is disposed between the array substrate and the opposite substrate. The backlight module is disposed opposite to the display panel.

In an embodiment of the present invention, the first source and the first drain respectively have at least one I-shaped structure, and an included angle between an extending direction of the I-shaped structure and the curvature central axis is 85 degrees to 95 degrees.

In an embodiment of the present invention, the scan lines are sequentially disposed on the substrate along the extending direction of the curvature central axis, or the data lines are sequentially disposed on the substrate along the extending direction of the curvature central axis.

In an embodiment of the present invention, the at least one shift register further includes an input unit. The input unit includes a second transistor. The second transistor includes a second gate, a second channel layer, a second source, and a second drain. The second source and the second drain are disposed overlapping with the second channel layer, where the second drain is electrically connected to the first gate. There is a second channel width and a second channel length between the second source and the second drain. A region constituted by the second channel length along the extending direction of the curvature central axis has an occupied length. A ratio of the occupied length of the second channel length along the extending direction of the curvature central axis to the second channel width is more than 50%.

In an embodiment of the present invention, the at least one shift register further includes a pull-down unit, configured to pull down the gate signal outputted by the pull-up unit to a low power supply voltage. The pull-down unit includes a third transistor. The third transistor includes a third gate, a third channel layer, a third source, and a third drain. The third source and the third drain are disposed corresponding to the third gate and the third channel layer. There is a third channel width and a third channel length between the third source and the third drain. A region constituted by the third channel length along the extending direction of the curvature central axis has an occupied length. A ratio of the occupied length of the third channel length along the extending direction of the curvature central axis to the third channel width is more than 50%.

In an embodiment of the present invention, the first source is configured to be electrically connected to a clock signal source.

By means of the foregoing structure, when the display apparatus bends, a change amount of an overall channel length of the first transistor is not large. A turning on current (Ion) of the first transistor is inversely proportional to the channel length. The overall channel length of the first transistor does not obviously change when bending of the display device. Therefore, the turning on current of the first transistor does not generate loss due to bending of the display device.

### BRIEF DESCRIPTION OF THE DRAWINGS

FIG. 1 is a side view of a display device according to an embodiment of the present invention.
FIG. 2 is a front view of an array substrate of FIG. 1.
FIG. 3 is a circuit diagram of a shift register of FIG. 2.
FIG. 4 is a schematic top view of the shift register of FIG. 2 according to an embodiment of the present invention.
FIG. 5 is an enlarged view of a region M of FIG. 4.
FIG. 6 is a cross-sectional view along a line segment 6-6 of FIG. 5.
FIG. 7 is a schematic top view of the shift register of FIG. 2 according to another embodiment of the present invention.
FIG. 8A is an enlarged view of a region N of FIG. 7.
FIG. 8B is an enlarged view of a region O of FIG. 7.
FIG. 9 is a schematic top view of a shift register of a comparative example.
FIG. 10A is a relationship diagram of turning on current (Ion) values of the transistor T21 having different channel lengths and channel widths in FIG. 4 before and after an array substrate bends.
FIG. 10B is a relationship diagram of turning on current (Ion) values of the transistor T21' having different channel lengths and channel widths in FIG. 9 before and after an array substrate bends.

### DETAILED DESCRIPTION

A plurality of embodiments of the present invention are disclosed below with accompanying drawings. For description clearness, a lot of practical details are described together in the following description. However, it should be known that the practical details should not be intended to limit the present invention. That is, in some embodiments of the present invention, the practical details are unnecessary. In addition, to simplify drawings, some conventional structures and elements are drawn in a simple illustrative manner in the drawings.

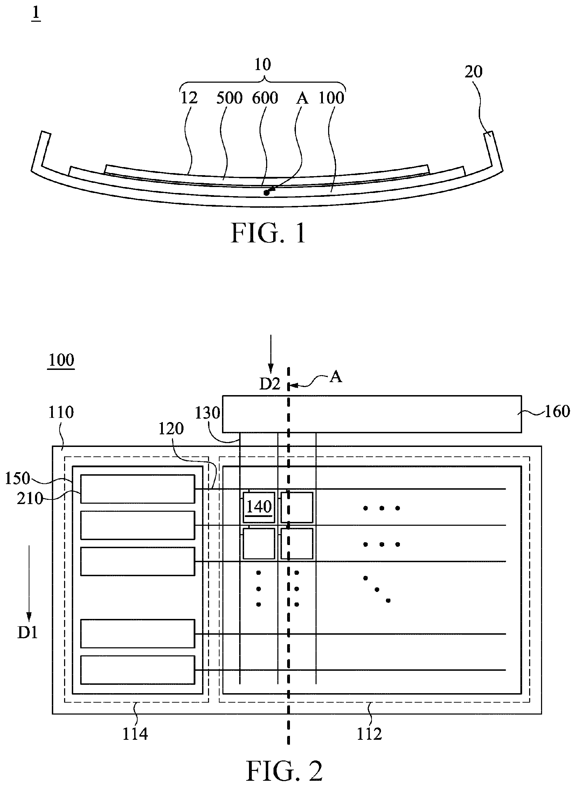

FIG. 1 is a side view of a display device 1 according to an embodiment of the present invention. The display device 1 includes a display panel 10 and a backlight module 20. The backlight module 20 is disposed opposite to the display panel 10. The display panel 10 has a display surface 12 that bends along a curvature central axis A, that is, the display device 1 may be a curved display device, which can bend along the curvature central axis A (the display device 1 can bend by using the curvature central axis A as an axis), as shown in FIG. 1. The display panel 10 includes an array substrate 100, an opposite substrate 500, and a display medium 600. The display medium 600 is disposed between the array substrate 100 and the opposite substrate 500. In addition, the array substrate 100 is disposed between the opposite substrate 500 and the backlight module 20. The opposite substrate 500 may be a transparent material, and there may be a light shield layer thereon (not shown). The display medium 600 varies according to types of the display panel 10, for example, the display medium 600 of a liquid crystal display panel is a liquid crystal molecule; the display medium 600 of an electrowetting display panel is a polar or nonpolar liquid, and the display medium 600 of an electrophoretic display panel is a microcapsule.

FIG. 2 is a front view of the array substrate 100 of FIG. 1. The array substrate 100 includes a substrate 110, at least one scan line 120, at least one data line 130, at least one pixel unit 140, and a gate driving circuit 150. For example, in FIG. 2, the array substrate 100 includes a plurality of scan lines 120, a plurality of data lines 130, and a plurality of pixel units 140. The data lines 130 are intersected with the scan lines 120, for example, the data lines 130 are substantially perpendicular to the scan lines 120, but the present invention is not limited thereto. It is understood that the term "substantially" stated throughout this specification is used for describing any feature, which can be modified slightly, but the essence of the feature will not be changed by the slight modification. The substrate 110 has a display region 112 and a peripheral region 114 located on at least one side of the display region 112. For example, in FIG. 2, the peripheral region 114 is located on the left side of the display region 112. However, in other embodiments, the peripheral region 114 may be located on the left side, the right side, the upper side and/or the lower side of the display region 112, disposed surrounding the display region 112, or disposed on two opposite sides of the display region 112. The present invention is not limited thereto. The pixel units 140 are electrically connected to the scan lines 120 and the data lines 130. The at least one pixel unit 140 is disposed in the display region 112 of the substrate 110. The gate driving circuit 150 is disposed in the peripheral region 114. The gate driving circuit 150 includes a plurality of shift registers 210 sequentially disposed on the substrate 110 along a first direction D1, and the scan lines 120 are also sequentially disposed on the substrate 110 along the first direction D1. The plurality of shift registers 210 is configured to output a plurality of gate signals (or scan signals). The shift registers 210 respectively correspond to the plurality of scan lines 120, and drive the scan lines 120 at a predetermined sequence. In addition, the array substrate 100 may further include a source driving circuit 160, which is electrically connected to and drives the data lines 130.

In some embodiments, an extending direction D2 of the curvature central axis A of the display panel 10 (shown in FIG. 1) is substantially the same as the first direction D1. In other words, the shift registers 210 and the scan lines 120 are sequentially disposed on the substrate 110 separately along the extending direction D2 of the curvature central axis A. In some embodiments, an included angle between the extending direction D2 of the curvature central axis A and the first direction D1 may be less than 5 degrees, for example, when the extending direction D2 is the same as the first direction D1, then the included angle is 0 degree, as shown in FIG. 2. However, in other embodiments, the data lines 130 may be sequentially disposed on the substrate 110 along the extending direction D2 of the curvature central axis A. The present invention is not limited thereto.

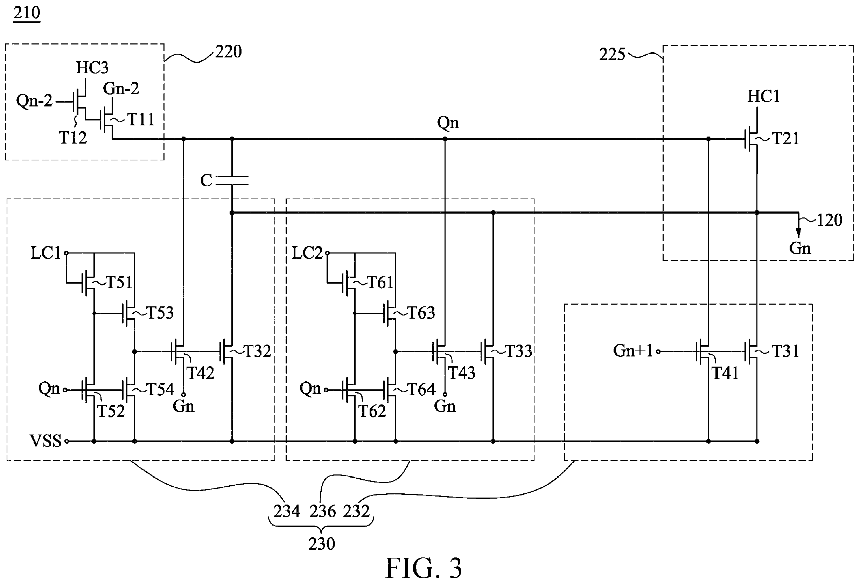

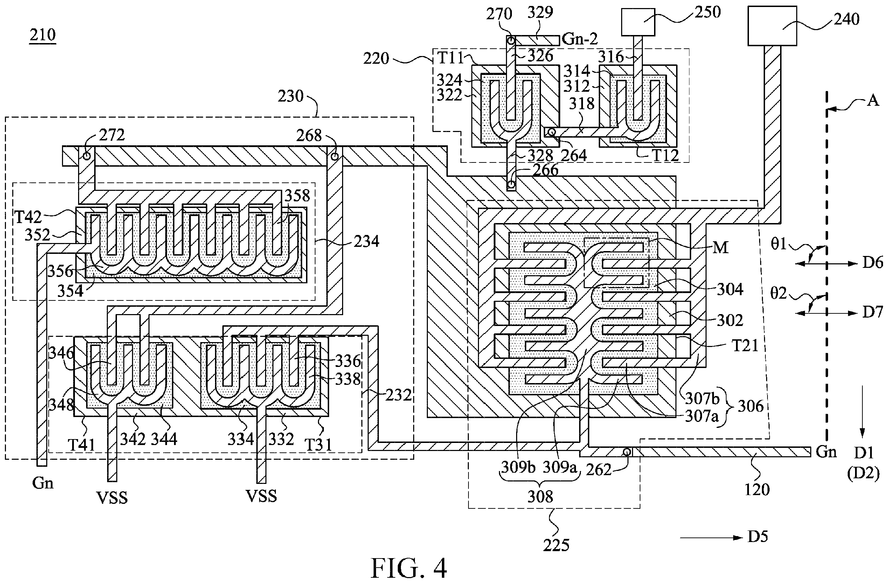

FIG. 3 is a circuit diagram of the shift register 210 of FIG. 2. FIG. 4 is a schematic top view of the shift register 210 of FIG. 2 according to an embodiment of the present invention. Refer to FIG. 3 and FIG. 4 together. The shift register 210 includes an input unit 220, a pull-up unit 225, and a pull-down unit 230. It should be noted that for clearness, only some elements of the pull-down 230 of FIG. 4 are drawn, and some elements are omitted, and relative locations between the input unit 220, the pull-up unit 225, and the pull-down unit 230 of FIG. 4 are only exemplary, and are not intended to limit the present invention. A person of ordinary skill in the art may flexibly design the relative locations between the input unit 220, the pull-up unit 225, and the pull-down unit 230 according to actual requirements.

The input unit 220 is configured to output a driving control voltage Qn according to input signals Qn-2 and Gn-2 and a clock signal HC3, where the input signals Qn-2 and Gn-2 are respectively a driving control voltage signal and a gate signal of two upper shift registers of the shift registers 210 drawn in FIG. 3 and FIG. 4. The pull-up unit 225 is electrically connected to the input unit 220 and a corresponding scan line 120, and is configured to pull up a gate signal Gn according to the driving control voltage Qn and a clock signal HC1. However, the scan line 120 connected to the pull-up unit 225 is configured to transmit the gate signal Gn. The pull-down unit 230 is electrically connected to the input unit 220 and the pull-up unit 225, and is configured to pull down the gate signal Gn outputted by the pull-up unit 225 to a low power supply voltage VSS.

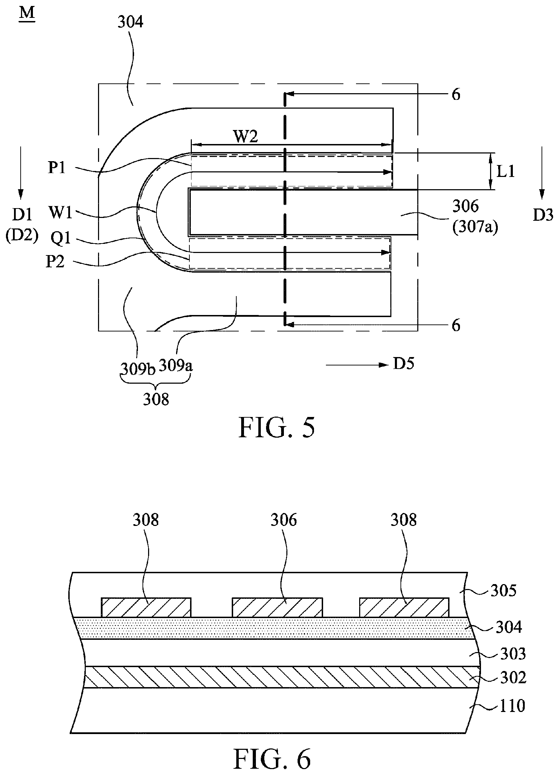

FIG. 5 is an enlarged view of a region M of FIG. 4. FIG. 6 is a cross-sectional view along a line segment 6-6 of FIG. 5. Refer to FIG. 4 to FIG. 6 together. The pull-up unit 225 includes a transistor T21, configured to output the gate signal Gn (shown in FIG. 3) to the scan line 120. Specifically, the transistor T21 includes a gate 302, a channel layer 304, a source 306, and a drain 308. The source 306 and the drain 308 are disposed corresponding to the gate 302 and the channel layer 304. For example, in FIG. 6, the gate 302 is disposed on the substrate 110; the channel layer 304 is disposed on the gate 302; and the source 306 and drain 308 are disposed on the channel layer 304, and the configuration is a bottom gate transistor structure. In some embodiments, a dielectric layer 303 may be disposed between the channel layer 304 and the gate 302, and a protection layer 305 may cover the source 306, the drain 308, and the channel layer 304 for protection. However, in other embodiments, the transistor T21 may be a top gate transistor structure, that is, the channel layer is disposed on the source and the drain, and the gate is disposed over the channel layer, or other suitable transistor structures. The present invention is not limited thereto.

The source 306 has at least one bar portion 307a, and the drain 308 has at least one bar portion 309a. For example, as shown in FIG. 4, the source 306 has eight bar portions 307a, and the drain 308 has ten bar portions 309a. However, the present invention is not limited thereto. In other embodiments, the numbers of the bar portions 307a and 309a may be selected according to actual requirements. In FIG. 5, there is an extending direction D3 of a channel length L1 between two adjacent bar portions 307a and 309a of the source 306 and the drain 308. The channel length L1 is a length of the channel layer 304 in a flow direction of current (or an electron flow), and is a distance between the bar portions 307a and 309a in the present disclosure. However, the extending direction D3 is a flow direction of current (or an electron flow) between the bar portion 307a of the source 306 and the bar portion 309a of the drain 308. The extending direction D3 is along the first direction D1. In other words, the extending direction D3 is substantially parallel to the first direction D1 or the same as the first direction D1.

From another aspect, there is further a channel width W1 between the source 306 and the drain 308, and the channel width W1 is a width, in a direction substantially perpendicular to the channel length L1, of the channel layer 304. According to FIG. 5, the extending direction D3 of the channel length L1 is along the extending direction D2 of the curvature central axis A (shown in FIG. 4) (also the first direction D1 in the present implementation manner). A region is constituted by the channel length L1 extending along the extending direction D2 of the curvature central axis A and the region has an occupied length. A ratio of the occupied length of the first channel length L1 extending along an extending direction D2 of the curvature central axis A to the channel width W1 is more than 50%. Specifically, according to FIG. 5, in regions P1 and P2, the extending direction D3 of the channel length L1 is along the first direction D1 (also the extending direction D2), that is, in the regions P1 and P2, the extending direction D3 and the first direction D1 are substantially parallel to or the same as the extending direction D2. A ratio of an occupied length sum (W2+W2) of the regions P1 and P2 to the channel width W1 is more than 50%.

By means of such a structure, when the display device 1 of FIG. 1 bends along the curvature central axis A, in the regions P1 and P2, the extending direction D3 of the channel length L1 of the transistor T21 is substantially the same as the extending direction D2 of the curvature central axis A (also the first direction D1 in the present implementation manner), so the channel length L1 in the regions P1 and P2 almost makes no change or has a small change amount when the display device bends. That is, the channel length L1 is almost not increased or only has a small increasing amplitude when the display device bends. In addition, because the ratio of the occupied length sum of the regions P1 and P2 to the channel width W1 is more than 50%, when the display device bends, a change amount of the overall channel length L1 of the transistor T21 is not large. A turning on current (Ion) of the transistor T21 is inversely proportional to the channel length L1. The overall channel length L1 of the transistor T21 does not obviously change when bending of the display device. Therefore, the turning on current of the transistor T21 does not generate loss due to bending of the display device. If the turning on current generates an excessively large loss, a case of insufficient charging or mischarging may occur, and the structure of the present implementation manner can improve the conditions. In some embodiments, a loss amplitude of the turning on current is less than about 15%.

Refer to FIG. 4 and FIG. 5. The drain 308 of the transistor T21 further has a connection portion 309b, which is connected to two bar portions 309a of the drain 308, that is, the bar portions 309a are electrically connected to each other by means of the connection portion 309b. The connection portion 309b and the two bar portions 309a form a U shape. However, the present invention is not limited thereto. In FIG. 4, a shape of the drain 308 may be formed by a plurality of U shapes arranged repeatedly and/or arranged in a mirror-image manner, that is, the connection portion 309b may be connected to a plurality of bar portions 309a, and therefore the drain 308 may form a comb-shaped structure on the whole.

On the other aspect, the bar portions 307a of the source 306 may be I-shaped, and extend along an extending direction D5 of the scan line 120, that is, the bar portions 307a may be substantially parallel to the scan line 120. The source 306 may further include a connection portion 307b connected to the bar portions 307a, that is, the bar portions 307a are electrically connected to each other by means of the connection portion 307b. The source 306 may be in another comb-shaped structure on the whole. However, in other embodiments, the shape of the source 306 may be contrary to that of the drain 308, that is, the source 306 may be U-shaped, and the bar portion 309a of the drain 308 may be I-shaped.

Refer to FIG. 4. The bar portions 309a of the drain 308 and the bar portions 307a of the source 306 are all I-shaped. An included angle θ1 between an extending direction D6 of the bar portions 307a and the curvature central axis A is 85 to 95 degrees, for example, about 90 degrees. In addition, an included angle θ2 between an extending direction D7 of the bar portions 309a and the curvature central axis A is also 85 to 95 degrees, for example, about 90 degrees. In addition, the bar portions 309a are alternately disposed with 307a along the first direction D1 (also the extending direction D2 of the curvature central axis A in the present implementation manner). Such a structure may increase the ratio between the channel width W1 and the channel length L1 (drawn in FIG. 5), so as to increase a turning on current of the transistor T21. A total channel width of the transistor T21 is a sum of the channel width W1 (shown in FIG. 5) of each U-shaped drain 308. For example, in FIG. 4, the drain 308 is formed by eight U shapes, and therefore, the total channel width of the transistor T21 is 8W1. It should be noted that, in FIG. 4, the transistor T21 is formed by a transistor unit (a U-shaped drain 308 and an I-shaped source 306) drawn in FIG. 5 arranged repeatedly. However, in other embodiments, the transistor T21 may be formed by one bar-shaped source and one bar-shaped drain that are arranged in a substantive parallel manner. It is within the range of the present invention as long as an extending direction of the channel length of the transistor T21 substantially extends along the first direction D1 (and/or the extending direction D2 of the curvature central axis A).

Return to FIG. 3 and FIG. 4. The gate 302 of the transistor T21 is electrically connected to the input unit 220, which is configured to output the driving control voltage Qn to the gate 302. The source 306 of the transistor T21 is configured to be electrically connected to a clock signal source 240, which provides the clock signal HC1. The drain 308 of the transistor T21 is electrically connected to a corresponding scan line 120, for example, the drain 308 is connected to the scan line 120 by means of a penetration structure 262.

The input unit 220 includes transistors T11 and T12. A gate 312 of the transistor T12 receives the input signal Qn-2, and a source 316 of the transistor T12 is electrically connected to a clock signal source 250, which provides the input signal HC3. The input signals HC3 and HC1 may have same or different working periods. A drain 318 of the transistor T12 is electrically connected to a gate 322 of the transistor T11, for example, the drain 318 is connected to the gate 322 by means of a penetration structure 264, and a source 326 of the transistor T11 receives the input signal Gn-2, for example, the source 326 is connected to a connection line 329 by means of a penetration structure 270, and the input signal Gn-2 is transmitted to the source 326 by means of the connection line 329 and the penetration structure 270. A drain 328 of the transistor T11 is connected to the gate 302 of the transistor T21 of the pull-up unit 225, for example, the drain 328 is connected to the gate 302 by means of a penetration structure 266, so as to output the driving control voltage Qn to the gate of the transistor T21 of the pull-up unit 225.

The drain 308 and the gate 302 of the transistor T21 of the pull-up unit 225 are electrically connected to the pull-down unit 230. The pull-down unit 230 includes a main pull-down unit 232, a first auxiliary pull-down unit 234, and a second auxiliary pull-down unit 236. For clearness, the second auxiliary pull-down unit 236 is not drawn in FIG. 4. The main pull-down unit 232 includes transistors T31 and T41. A gate 332 of the transistor T31 and a gate 342 of T41 receive an input signal Gn+1, which is a gate signal outputted by a next shift register of the shift register 210 drawn in FIG. 3 and FIG. 4. A source 336 of the transistor T31 is electrically connected to the drain 308 of the transistor T21. A drain 338 of the transistor T31 is electrically connected to the low power supply voltage VSS. A channel layer 334 of the transistor T31 is disposed below the source 336 and the drain 338 and on the gate 332. A source 346 of the transistor T41 is electrically connected to the gate 302 of the transistor T21, for example, the source 346 is connected to the gate 302 by means of a penetration structure 268, and a drain 348 of the transistor T41 is electrically connected to the low power supply voltage VSS. A channel layer 344 of the transistor T41 is disposed below the source 346 and the drain 348 and on the gate 342.

In FIG. 4, shapes of the source 336 and the source 346 are a plurality of I shapes. However, shapes of bar portions of the drain 338 and the drain 348 are U shapes. However, in other embodiments, shapes of the source 336 (346) and the drain 338 (348) may be contrary, or are both elongated, or other suitable shapes. The present invention is not limited thereto. In addition, the transistors T31 and T41 may be top gate transistor structures or other suitable transistor structures.

The first auxiliary pull-down unit 234 includes transistors T32, T42, T51, T52, T53, and T54. For clearness, FIG. 4 only draws the transistor T42. A gate of the transistor T32 and a gate 352 of the transistor T42 are electrically connected to a drain of the transistor T53 and a source of the transistor T54. A source of the transistor T32 is electrically connected to the gate 302 of the transistor T21 by means of a capacitor C, and is electrically connected to the drain 308 of the transistor T21. A drain of the transistor T32 is electrically connected to the low power supply voltage VSS. A source 356 of the transistor T42 is electrically connected to the gate signal Gn, and a drain 358 of the transistor T42 is electrically connected to the gate 302 of the transistor T21, for example, the drain 358 is connected to the gate 302 by means of a penetration structure 272. A channel layer 354 of the transistor T42 is disposed below the source 356 and the drain 358 and on the gate 352. A gate of the transistor T51 is electrically connected to a source of the transistor T51 and a source of the transistor T53 for receiving a clock signal LC1, and a drain of the transistor T51 is electrically connected to a source of the transistor T52 and a gate of the transistor T53. A gate of the transistor T52 is electrically connected to a gate of the transistor T54 for receiving the input signal Qn, and a drain of the transistor T52 and a drain of the transistor T54 are electrically connected to the low power supply voltage VSS.

In FIG. 4, the shape of the source 356 is a plurality of U shapes. However, the shapes of the bar portions of the drain 358 are I shapes. However, in other embodiments, shapes of the source 356 and the drain 358 may be contrary, or are both elongated, or other suitable shapes. The present invention is not limited thereto. In addition, the transistors T32, T51, T52, T53, and T54 may have same or different transistor structures as the transistor T42, and the transistors T32, T42, T51, T52, T53, and/or T54 may be top gate transistor structures or other suitable transistor structures.

The second auxiliary pull-down unit 236 includes transistors T33, T43, T61, T62, T63, and T64, where a wire layout of the transistor T43 is the same as that of the transistor T42 in FIG. 4. A gate of the transistor T33 and a gate of the transistor T43 are electrically connected to a drain of the transistor T63 and a source of the transistor T64. A source of the transistor T33 is electrically connected to the gate 302 of the transistor T21 by means of the capacitor C, and is electrically connected to the drain 308 of the transistor T21. A drain of the transistor T33 is electrically connected to the low power supply voltage VSS. A source of the transistor T43 is electrically connected to the gate signal Gn, and a drain of the transistor T43 is electrically connected to the gate 302 of the transistor T21. A gate of the transistor T61 is electrically connected to a source of the transistor T61 and a source of the transistor T63 for receiving a clock signal LC2, where a substantive difference between a phase of the clock signal LC2 and that of the clock signal LC1 may be 180 degrees. A drain of the transistor T61 is electrically connected to a source of the transistor T62 and a gate of the transistor T63. A gate of the transistor T62 is electrically connected to a gate of the transistor T64 for receiving the input signal Qn, and a drain of the transistor T62 and a drain of the transistor T64 are electrically connected to the low power supply voltage VSS.

In some embodiments, the transistors T33, T43, T61, T62, T63, and T64 may have same or different transistor structures as the transistor T42 in FIG. 4. Or the transistors T33, T43, T61, T62, T63, and/or T64 may be top gate transistor structures or other suitable transistor structures.

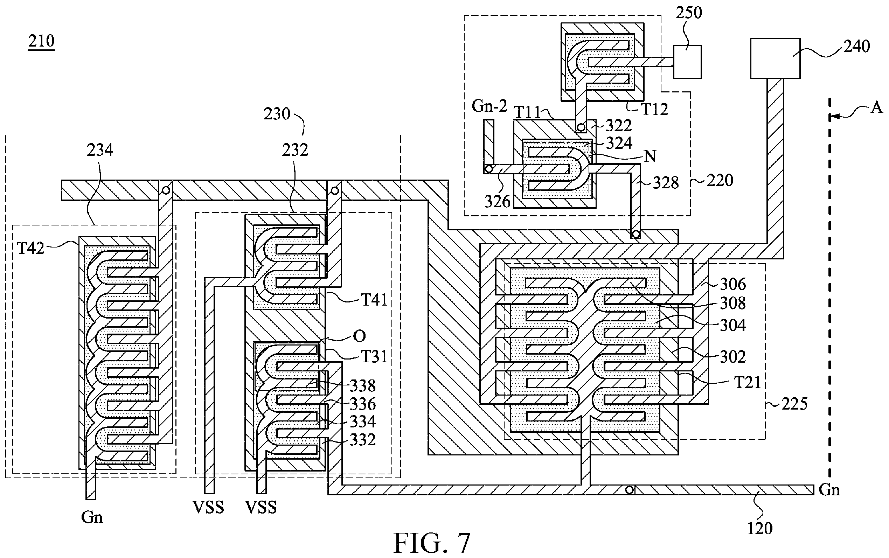

FIG. 7 is a schematic top view of the shift register 210 of FIG. 2 according to another implementation manner. FIG. 7 differs from FIG. 4 in respect of directions of the transistors T11, T12, T31, T41, and T42. In FIG. 7, the directions of the transistors T11, T12, T31, T41, and T42 are substantially the same as that of the transistor T21, that is, the transistors T11, T12, T31, T41, and T42 in FIG. 4 all rotate for about 90 degrees or 270 degrees.

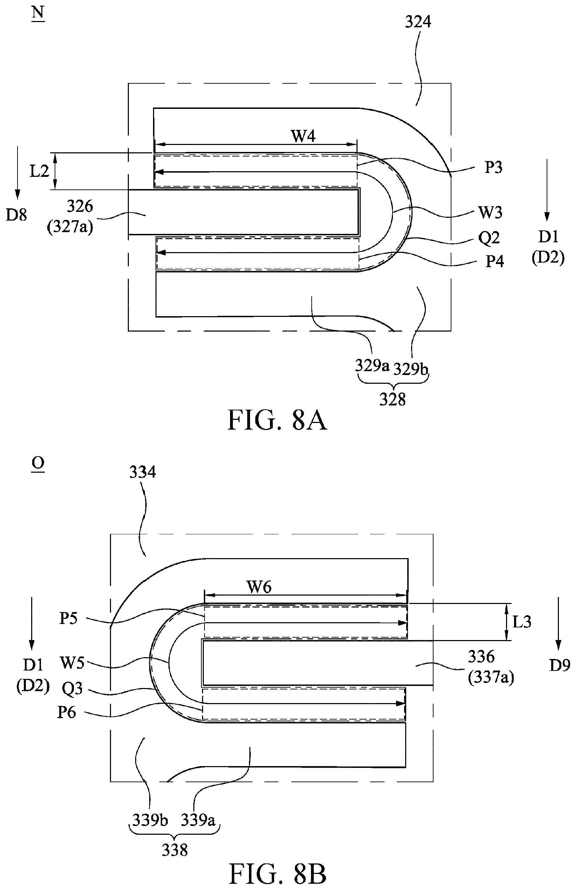

In detail, referring to FIG. 8A, FIG. 8A is an enlarged view of a region N of FIG. 7. The source 326 of the transistor T11 has at least one bar portion 327a, and the drain 328 has at least one bar portion 329a. For example, in FIG. 7, the source 326 has one bar portion 327a, and the drain 328 has 2 bar portions 329a. However, the present invention is not limited thereto. In other embodiments, the numbers of the bar portions 327a and 329a may be selected according to actual requirements. In FIG. 8A, there is an extending direction D8 of a channel length L2 between two adjacent bar portions 327a and 329a of the source 326 and the drain 328. The channel length L2 is a length of a channel layer 324 in a flow direction of current (or an electron flow), and is a distance between the bar portion 327a of the source 326 and the bar portion 329a of the drain 328 in the present disclosure. However, the extending direction D8 is a flow direction of current (or an electron flow) between the bar portions 327a and 329a. The extending direction D8 is along the first direction D1. In other words, the extending direction D8 is substantially parallel to the first direction D1 or the same as the first direction D1.

From another aspect, there is further a channel width W3 between the source 326 and the drain 328, and the channel width W3 is a width, in a direction substantially perpendicular to the channel length L2, of the channel layer 324. According to FIG. 8A, the extending direction D8 of the channel length L2 is along the extending direction D2 of the curvature central axis A (shown in FIG. 7) (also the first direction D1 in the present implementation manner). A region is constituted by the channel length L2 extending along the extending direction D2 of the curvature central axis A and the region has an occupied length. A ratio of the occupied length of the channel length L2 extending along the extending direction D2 of the curvature central axis A to the channel width W3 is more than 50%. Specifically, according to FIG. 8A, in regions P3 and P4, the extending direction D8 of the channel length L2 is along the first direction D1 (also the extending direction D2), that is, in the regions P3 and P4, the extending direction D8 and the first direction D1 are substantially parallel to or the same as the extending direction D2. A ratio of an occupied length (W4+W4) of the regions P3 and P4 to the channel width W3 is more than 50%. Other details of the transistor T11 of the present implementation manner are similar to those of the transistor T21, and therefore details are not described herein again. In addition, a transistor structure of the transistor T12 is also similar to that of T11, and therefore details are not described herein again.

Referring to FIG. 8B, FIG. 8B is an enlarged view of a region O of FIG. 7. The source 336 of the transistor T31 has at least one bar portion 337a, and the drain 338 has at least one bar portion 339a. For example, in FIG. 7, the source 336 has three bar portions 337a, and the drain 338 has four bar portions 339a. However, the present invention is not limited thereto. In other embodiments, the numbers of the bar portions 337a and 339a may be selected according to actual requirements. In FIG. 8B, there is an extending direction D9 of a channel length L3 between two adjacent bar portions 337a and 339a of the source 336 and the drain 338. The channel length L3 is a length of the channel layer 334 in a flow direction of current (or an electron flow), and is a distance between the bar portions 337a and 339a in the present disclosure. However, the extending direction D9 is a flow direction of current (or an electron flow) between the bar portions 337a and 339a. The extending direction D9 is along the first direction D1. In other words, the extending direction D9 is substantially parallel to the first direction D1 or the same as the first direction D1.

From another aspect, there is further a channel width W5 between the source 336 and the drain 338, and the channel width W5 is a width, in a direction substantially perpendicular to the channel length L3, of the channel layer 334. According to FIG. 8B, the extending direction D9 of the channel length L3 is along the extending direction D2 of the curvature central axis A (shown in FIG. 7) (also the first direction D1 in the present implementation manner). A region is constituted by the channel length L3 extending along the extending direction D2 of the curvature central axis A and the region has an occupied length. A ratio of the occupied length of the first channel length L3 extending along an extending direction D2 of the curvature central axis A to the channel width W5 is more than 50%. Specifically, according to FIG. 8B, in regions P5 and P6, the extending direction D9 of the channel length L3 is along the first direction D1 (also the extending direction D2), that is, in the regions P5 and P6, the extending direction D9 and the first direction D1 are substantially parallel to or the same as the extending direction D2. A ratio of an occupied length sum (W6+W6) of the regions P5 and P6 to the channel width W5 is more than 50%. Other details of the transistor T31 of the present implementation manner are similar to those of the transistor T21, and therefore details are not described herein again. In addition, transistor structures of the transistors T41 and T42 in FIG. 7 are also similar to that of T21, and therefore details are not described herein again.

Although in FIG. 7, the transistors T11, T12, T21, T31, T41, and T42 have same directions, in other embodiments, the transistors T11, T12, T31, T32, T33, T41, T42, T43, T51, T52, T53, T54, T61, T62, T63, and/or T64 have directions substantially the same as that of the transistor T21, and are all within the range of the present invention.

Return to FIG. 2. In some embodiments, the array substrate 100 is a flexible substrate, that is, the substrate 110 is a flexible material, for example, polyimide (PI), polycarbonate (PC), polyethersulfone (PES), polynorbornene (PNB), polyetherimide (PEI), (poly(p-phenylene benzobisimidazole) (PBI), poly(p-phenylene benzobisoxazole) (PBO), poly(p-phenylene terephthalamide) (PPTA), or a combination thereof. The array substrate 100 can bend along the curvature central axis A.

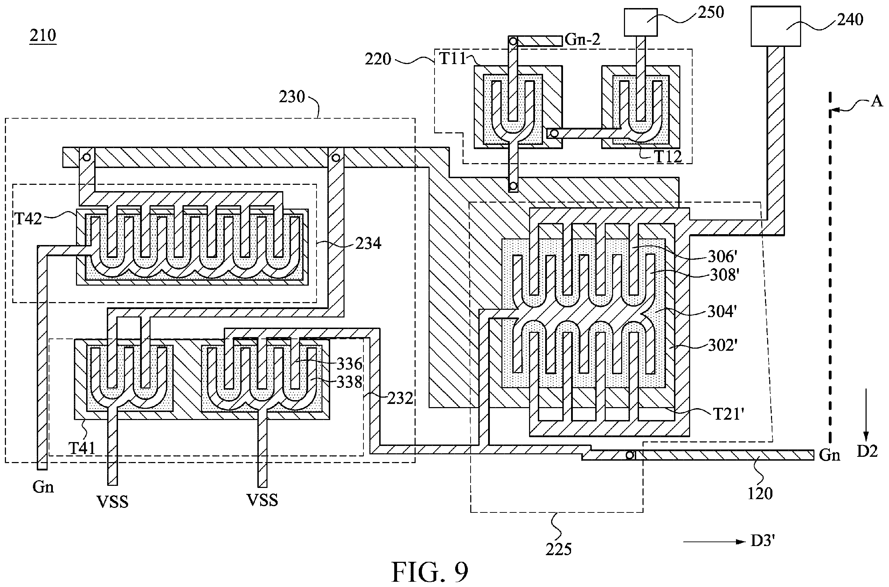

Comparison and description are made below on a comparative example of the display device and an embodiment of the foregoing display device 1. FIG. 9 is a schematic top view of a shift register of the comparative example. In FIG. 9, the extending direction D2 of the curvature central axis A is the same as the first direction D1 (shown in FIG. 4). A transistor T21' includes a gate 302', a channel layer 304', a source 306', and a drain 308'. Therefore is an extending direction D3' of a channel length between two adjacent bar portions of the source 306' and the drain 308'. The extending direction D3' is substantially perpendicular to the extending direction D2. That is, the transistor T21' of FIG. 9 rotates for about 90 degrees relative to the transistor T21 of FIG. 4. Other details of FIG. 9 are similar to those of FIG. 4, and therefore details are not described herein again.

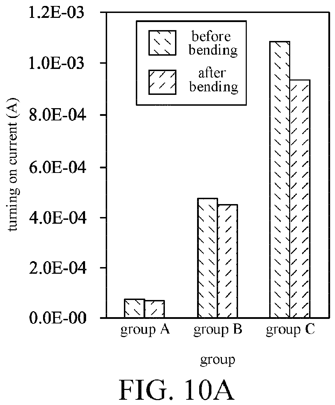

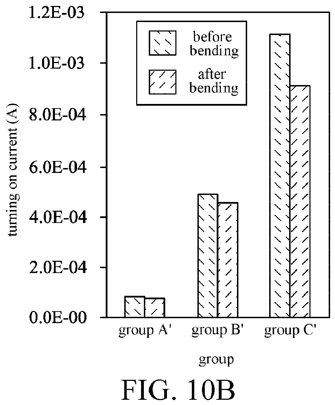

FIG. 10A is a relationship diagram of turning on current (Ion) values of the transistor T21 having different channel lengths and channel widths in FIG. 4 before and after the array substrate bends, and FIG. 10B is a relationship diagram of turning on current (Ion) values of the transistor T21' having different channel lengths and channel widths in FIG. 9 before and after the array substrate bends. In embodiments of group A and group A', the channel length is about 4.5µm, and the channel width is about 100µm; in embodiments of group B and group B', the channel length is about 4.5µm, and the channel width is about 500µm; and in embodiments of group C and group C', the channel length is about 4.5µm, and the channel width is about 1000µm. In each group of embodiments, the array substrate is substantially planar when the array substrate does not bend. However, a bending curvature diameter of the array substrate is about 2000mm, and a voltage difference between the source and drain is about 15V, and a voltage difference between the gate and the source is about 20V.

In FIG. 10A, after the array substrate bends, the turning on current (Ion) slightly decreases. When the channel width is 100µm, the turning on current (Ion) decreases by about 3%; when the channel width is 500µm, the turning on current (Ion) decreases by about 4%; and when the channel width is 1000µm, the turning on current (Ion) decreases by about 14%. In addition, in the comparative example of FIG. 10B, after the array substrate bends, a decreasing amplitude of the turning on current is large. When the channel width is 100µm, the turning on current decreases by about 6%; when the channel width is 500µm, the turning on current decreases by about 7%; and When the channel width is 1000µm, the turning on current decreases by about 18%. According to the foregoing data, it can be known that with respect to the comparative example, when the array substrate has the structure of the transistor T21, loss of the turning on current is small, that is, the transistor structure of each embodiment of the present invention can effectively improve the loss of the power-up current.

## Claims

1. An array substrate (100), comprising:
a substrate (110), having a display region (112) and a peripheral region (114) located on at least one side of the display region (112);
at least one scan line (120);
at least one data line (130), intersected with the at least one scan line (120);
at least one pixel unit (140), electrically connected to the at least one scan line (120) and the at least one data line (130), wherein the at least one pixel unit (140) is disposed in the display region (112) of the substrate (110); and
a gate driving circuit (150), disposed in the peripheral region (114), wherein the gate driving circuit (150) comprises a plurality of shift registers (210) sequentially disposed on the substrate (110) along a first direction (D1), at least one of the plurality of shift registers (210) comprises a pull-up unit (225), and the pull-up unit (225) comprises:
a first transistor (T21), configured to output a gate signal (Gn) to the scan line (120), wherein the first transistor (T21) comprises:
a first gate (302) and a first channel layer (304); and
a first source (306) and a first drain (308), disposed corresponding to the first gate (302) and the first channel layer (304), wherein the first source (306) and the first drain (304) respectively have at least one bar portion (307a, 309a), a first channel length (L1) is between the bar portion (307a) of the first source (306) and the bar portion (309a) of the first drain (308) being adjacent to each other, and an extending direction (D3) of the first channel length (L1) is along the first direction (D1).

2. The array substrate (100) according to claim 1, wherein the first drain (308) comprises two bar portions (309a), the first drain (308) further comprises a connection portion (309b) connected to the two bar portions (309a) of the first drain (308), and the two bar portions (309a) of the first drain (308) and the bar portion (307a) of the first source (306) are alternately disposed along the first direction (D1).

3. The array substrate (100) according to claim 1, wherein a shape of the first drain (308) comprises a U shape, and a shape of the first source (306) comprises an I shape.

4. The array substrate (100) according to claim 3, wherein the I shape of the first source (306) extends along an extending direction (D5) of the scan line (120).

5. The array substrate (100) according to claim 1, wherein the first drain (306) is electrically connected to the scan line (120).

6. The array substrate (100) according to claim 1, wherein the at least one shift register (210) further comprises an input unit (220), configured to output a driving control voltage (Qn) to the first gate (302) of the first transistor (T21) of the pull-up unit (225), the input unit (220) comprises a second transistor (T11, T12) and the second transistor (T11, T12) comprises:
a second gate (312, 322) and a second channel layer (314, 324); and
a second source (316, 326) and a second drain (318, 328), disposed corresponding to the second gate (312, 322) and the second channel layer (314, 324), wherein the second source (316, 326) and the second drain (318, 328) respectively have at least one bar portion (327a, 329a), a second channel length (L2) is between the bar portions (327a) of the second source (316, 326) and the bar portion (329a) of the second drain (328) being adjacent to each other, and an extending direction (D8) of the second channel length (L2) is along the first direction (D1).

7. The array substrate (100) according to claim 6, wherein the first gate (302) is electrically connected to the second drain (328).

8. The array substrate (100) according to claim 1, wherein the at least one of the plurality of shift registers (210) further comprises a pull-down unit (230), configured to pull down the gate signal (Gn) outputted by the pull-up unit (225) to a low power supply voltage (Vss).

9. The array substrate (100) according to claim 8, wherein the pull-down unit (230) comprises a third transistor (T31, T32, T33, T41, T42, T43, T51, T52, T53, T54, T61, T62, T63, T64), and the third transistor (T31, T32, T33, T41, T42, T43, T51, T52, T53, T54, T61, T62, T63, T64) comprises:
a third gate (332, 342, 352) and a third channel layer (334, 344, 354); and
a third source (336, 346, 356) and a third drain (338, 348, 358), disposed corresponding to the third gate (332, 342, 352) and the third channel layer (334, 344, 354), wherein the third source (336, 346, 356) and the third drain (338, 348, 358) respectively have at least one bar portion (337a, 339a), a third channel length (L3) is between the bar portions (337a) of the third source (336) and the bar portion (339a) of the third drain (338) being adjacent to each other, and an extending direction (D9) of the third channel length (L3) is along the first direction (D2).

10. The array substrate (100) according to claim 8, wherein the first drain (308) and the first gate (302) of the first transistor (T21) of the pull-up unit (225) are electrically connected to the pull-down unit (230).

11. The array substrate (100) according to claim 1, wherein the first source (306) is configured to be electrically connected to a clock signal source (240).

12. The array substrate (100) according to claim 1, wherein a first channel width (W1) is between the first source (306) and the first drain (308) of the first transistor (T21), a region (P1, P2) constituted by the first channel length (L1) extending along the first direction (D1) has an occupied length, and a ratio of the occupied length (P1, P2) to the first channel width (W1) is more than 50%.

13. The array substrate (100) according to claim 1, wherein the first source (306) and the first drain (308) respectively have at least one I-shaped structure, and an included angle (θ1, 02) between an extending direction (D6, D7) of the I-shaped structure and the first direction (D1) is 85 degrees to 95 degrees.
